# EUROPEAN PATENT APPLICATION

(11) **EP 4 746 292 A1**
(43) Date of publication of application: **20.05.2026**
(21) Application number: 24838758.1
(22) Date of filing: 08.07.2024
(51) Int. Cl.: H03H 9/25, H03H 9/145, H03H 9/13, H03H 9/02, H03H 3/08

(54) **SURFACE ACOUSTIC WAVE RESONATOR AND MANUFACTURING METHOD THEREFOR**

(30) Priority: 11.07.2023 CN 202310844732
(71) Applicant: Vanchip (Tianjin) Technology Co. Ltd, Tianjin 300457 (CN)
(72) Inventor: ZHU, Yong, Tianjin 300457 (CN); WU, Ziying, Tianjin 300457 (CN); LIANG, Qi, Tianjin 300457 (CN)
(74) Representative: Patentship Patentanwaltsgesellschaft mbH
(86) International application number: PCT/CN2024/104131
(87) International publication number: WO 2025/011505

(57) **Abstract**

The present application provides a surface acoustic wave resonator and a method for fabricating it. The surface acoustic wave resonator includes a plurality of interdigital electrodes and two busbar sets connected to the interdigital electrodes. In each busbar set, the busbar that is closer to the interdigital electrode forms an angle with a normal direction of the interdigital electrode. This provides for lateral mode suppression. In addition, mass blocks are provided at end portions of the interdigital electrodes to reduce the acoustic velocity at these ends. Further, each busbar set includes at least two busbars and adjacent busbars are connected. This enables energy confinement within an associated resonant cavity with suppressed energy leakage, eventually resulting in a greatly increased Q factor.

## Description

### TECHNICAL FIELD

The present application relates to the field of communications technology and, in particular, to a surface acoustic wave (SAW) resonator and a method for fabricating the resonator.

### BACKGROUND

Radio frequency (RF) front-ends are cores of modern mobile communications systems, and the performance of filters, which are employed in the RF front-ends as critical components, directly determines whether signals can stand out from noise in the communications systems. With the rapid development of the Internet of Things, the demand for data transmission capacity has further increased, requiring filters to have smaller in-band insertion loss and better out-of-band rejection. Resonators, as the fundamental building blocks of filters, are required to have a higher Q factor (Quality Factor). The thin-film surface acoustic wave (TF SAW) resonators developed in recent years employ a stack of layers to provide good energy confinement in the thickness direction, but this also introduces some lateral-mode response and lateral energy leakage, which lead to a reduced Q factor. Effort has been devoted in the art heretofore to developing higher Q-factor resonators.

### SUMMARY

It is an object of the present application to provide a surface acoustic wave resonator with an increased Q factor and a method for fabricating such a surface acoustic wave resonator.

To this end, the present application provides a surface acoustic wave resonator comprising a piezoelectric layer and an interdigital transducer formed on the piezoelectric layer.

The interdigital transducer comprises a plurality of interdigital electrodes and two busbar sets connected to the interdigital electrodes, wherein each busbar set comprises at least two busbars and adjacent busbars are connected. In each busbar set, the busbar that is closer to the interdigital electrode is oriented at an angle to a normal direction of the interdigital electrode. A mass block is provided at an end portion of the interdigital electrode.

Optionally, in the surface acoustic wave resonator, the busbar that is closer to the interdigital electrode in each busbar set may be oriented at an angle to a crystallographic x-axis of the piezoelectric layer.

Optionally, in the surface acoustic wave resonator, the two busbar sets may be of the same structure.

Optionally, in the surface acoustic wave resonator, adjacent busbars in each busbar set may be arranged in parallel or at an angle to each other.

Optionally, in the surface acoustic wave resonator, each busbar set may further comprise at least one connecting bar, wherein adjacent busbars in each busbar set are connected through the connecting bar.

Optionally, in the surface acoustic wave resonator, a maximum distance between adjacent busbars in each busbar set may be greater than or equal to a period of the interdigital electrodes.

Optionally, in the surface acoustic wave resonator, the angle between the busbar closer to the interdigital electrode in each busbar set and the normal direction of the interdigital electrode may range from 2° to 20°, or from -20° to -2°.

Optionally, in the surface acoustic wave resonator, the interdigital electrodes may comprise only active interdigital electrodes, wherein a first end of the active interdigital electrode is connected to the busbar set and a second end of the active interdigital electrode is provided with a mass block.

Alternatively, the interdigital electrodes may include active interdigital electrodes and dummy interdigital electrodes, wherein a first end of the active interdigital electrode and a first end of the dummy interdigital electrode are connected to different busbar sets, and a second end of the active interdigital electrode and/or a second end of the dummy interdigital electrode provided with a mass block.

Optionally, in the surface acoustic wave resonator, a ratio of a length of the mass block to a period of the interdigital electrode may be between 0.25 and 1, wherein the length of the mass block is a maximum dimension of the mass block along the extension of the interdigital electrode. Additionally, a ratio of a width of the mass block to a width of the interdigital electrode may be between 1.2 and 2, wherein the width of the mass block is a maximum dimension of the mass block along the normal direction of the interdigital electrodes.

Optionally, the surface acoustic wave resonator may further comprise reflectors located on opposite sides of the interdigital transducer.

Optionally, the surface acoustic wave resonator may further comprise a substrate layer, a trap layer and/or a first dielectric layer that are under the piezoelectric layer. Alternatively or additionally, the surface acoustic wave resonator may further comprise a second dielectric layer covering the interdigital transducer.

Optionally, in the surface acoustic wave resonator, the angle between the busbar closer to the interdigital electrode in each busbar set and the normal direction of the interdigital electrode may be equal to an angle of energy flow in the surface acoustic wave resonator. The present application also provides a method for fabricating a surface acoustic wave resonator, which comprises:
providing a piezoelectric layer;
forming an interdigital transducer on the piezoelectric layer, wherein the interdigital transducer comprises a plurality of interdigital electrodes and two busbar sets connected to the interdigital electrodes, wherein each busbar set comprises at least two busbars and adjacent busbars are connected, wherein in each busbar set, the busbar that is closer to the interdigital electrode is oriented at an angle to a normal direction of the interdigital electrode; and
forming a mass block at an end portion of the interdigital electrode.

Optionally, in the method for fabricating the surface acoustic wave resonator, forming the interdigital transducer on the piezoelectric layer may comprise:
forming a metal layer on the piezoelectric layer; and
etching the metal layer to form the interdigital transducer.

Optionally, in the method for fabricating the surface acoustic wave resonator, the mass block may comprise a metal mass layer, wherein when the metal layer is etched to form the interdigital transducer, the metal mass layer is formed.

As described above, the present application provides a surface acoustic wave resonator and a method for fabricating it. The surface acoustic wave resonator includes a plurality of interdigital electrodes and two busbar sets connected to the interdigital electrodes. In each busbar set, the busbar that is closer to the interdigital electrode is oriented at an angle to a normal direction of the interdigital electrode. This provides for lateral mode suppression. In addition, mass blocks are provided at ends of the interdigital electrodes to reduce the acoustic velocity at these ends. Further, each busbar set includes at least two busbars and adjacent busbars are connected. This enables energy confinement within an associated resonant cavity with suppressed energy leakage, eventually resulting in a greatly increased Q factor.

### BRIEF DESCRIPTION OF THE DRAWINGS

Fig. 1 shows a schematic cross-sectional view of a surface acoustic wave resonator according to an embodiment of the present application.
Fig. 2 shows a schematic cross-sectional view of another surface acoustic wave resonator according to an embodiment of the present application.
Fig. 3 shows a schematic cross-sectional view of yet another surface acoustic wave resonator according to an embodiment of the present application.
Fig. 4 shows a schematic cross-sectional view of still yet another surface acoustic wave resonator according to an embodiment of the present application.
Fig. 5 shows a schematic top view of an interdigital transducer in a surface acoustic wave resonator according to an embodiment of the present application.
Fig. 6 shows a schematic top view of an interdigital transducer in another surface acoustic wave resonator according to an embodiment of the present application.
Fig. 7 shows a schematic top view of an interdigital transducer in yet another surface acoustic wave resonator according to an embodiment of the present application.
Fig. 8 shows a schematic top view of an interdigital transducer in still yet another surface acoustic wave resonator according to an embodiment of the present application.
Fig. 9 shows a schematic top view of an interdigital transducer in a further surface acoustic wave resonator according to an embodiment of the present application.
Fig. 10 shows a schematic top view of an interdigital transducer in a further surface acoustic wave resonator according to an embodiment of the present application.
Fig. 11 shows a schematic top view of an interdigital transducer in a further surface acoustic wave resonator according to an embodiment of the present application.
Fig. 12 shows a schematic top view of an interdigital transducer in a further surface acoustic wave resonator according to an embodiment of the present application.
Fig. 13 shows a schematic top view of an interdigital transducer in a further surface acoustic wave resonator according to an embodiment of the present application.
Fig. 14 shows a schematic top view of an interdigital transducer in a further surface acoustic wave resonator according to an embodiment of the present application.
Fig. 15 shows a schematic top view of an interdigital transducer in a further surface acoustic wave resonator according to an embodiment of the present application.
Fig. 16 schematically illustrates a lateral-mode response comparison made between a surface acoustic wave resonator according to an embodiment of the present application and a conventional surface acoustic wave resonator.
Fig. 17 schematically illustrates a comparison made between Q factors according to embodiments of present application and conventional surface acoustic wave resonators.
Fig. 18 shows a schematic top view of an interdigital transducer in the conventional surface acoustic wave resonator.

### Reference Numerals

10-surface acoustic wave resonator;
100-piezoelectric layer; 110-substrate layer; 120-trap layer; 130-first dielectric layer; 140-second dielectric layer;
200-interdigital transducer; 210-interdigital electrode; 211-active interdigital electrode; 212-dummy interdigital electrode; 220-busbar set; 220a-upper busbar set; 220b-lower busbar set; 221-busbar; 2210a-first upper busbar; 2210b-first lower busbar; 2211a-second upper busbar; 2211b-second lower busbar; 222-connecting bar; 222a-upper connecting bar; 222b-lower connecting bar;
300-mass block;
400-reflector; 410-reflector grating; 420-reflector busbar set; 420a-upper reflector busbar set; 420b-lower reflector busbar set; 421-reflector busbar; 4210a-first upper reflector busbar; 4210b-first lower reflector busbar; 4211a-second upper reflector busbar; 4211b-second lower reflector busbar;
500-interdigital transducer; 510-interdigital electrode; 520-busbar;
F-normal; a1-first angle; a2-second angle; a3-third angle; H-distance; W-period; L1-length; L2, L3-width; S1, S2, S3, S4-graph.

### DETAILED DESCRIPTION

Surface acoustic wave (SAW) resonators and methods proposed herein will be described in greater detail below with reference to the accompanying drawings, which illustrate particular embodiments thereof. From the following description and claims, advantages and features of the present application will be more apparent. Note that the figures are rather simplified and not necessarily drawn to exact scale, with the only intention to facilitate easy and clear description of the embodiments disclosed herein.

The terminology used herein is for the purpose of describing particular embodiments only and is not intended to be limiting of the application. Unless defined otherwise herein, all technical and scientific terms used herein have the same meaning as commonly understood by one of ordinary skill in the art to which the application belongs. As used herein and in the appended claims, the terms "first," "second," and the like do not denote any order, quantity, or importance, but rather are used to distinguish one element from another. Likewise, the terms "a", "an" and the like do not denote a limitation of quantity, but rather denote the presence of at least one of the referenced items. The term "plurality" or "several" means two or more than two. Unless defined otherwise herein, the terms "upper", "upper layer", "lower", "lower layer" and/or the like are merely for ease of description, and should not be construed as being limited to a particular position, or to a particular spatial orientation. The use of "including" or "comprising" or the like herein is meant to encompass the elements or items listed thereafter and equivalents thereof but do not preclude the presence of other elements or items. The terms "connected", "coupled" or the like are not restricted to physical or mechanical connections or couplings, and can include electrical connections or couplings, whether direct or indirect. As used herein and in the appended claims, the singular forms "a", "an", and "the" are intended to include the plural forms as well, unless the context clearly indicates otherwise. It will be also understood that, as used herein, the term "and/or" includes any and all combinations of one or more of the associated listed items.

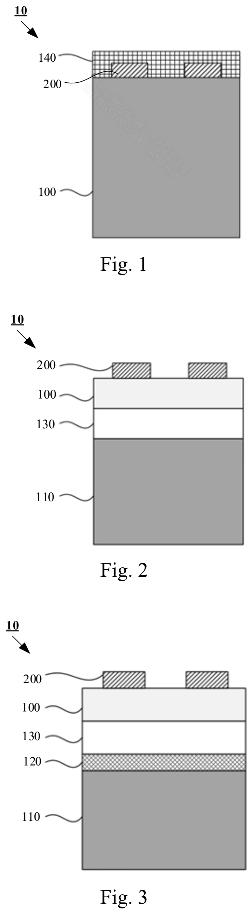

Reference is now made to Fig. 1, which shows a schematic cross-sectional view of a surface acoustic wave resonator according to an embodiment of the present application. As shown in Fig. 1, according to one embodiment disclosed herein, the surface acoustic wave resonator 10 includes a piezoelectric layer 100 and an interdigital transducer 200 formed on the piezoelectric layer 100. The piezoelectric layer 100 may be made of a material such as lithium tantalite (LT), lithium niobate (LN), aluminum nitride (AlN), lead zirconate titanate (PZT) piezoelectric ceramic, zinc oxide (ZnO) or the like. The piezoelectric layer 100 has mutually perpendicular crystallographic x-, y- and z-axes. The crystallographic x- and y-axes are parallel to a surface of the piezoelectric layer 100, and the crystallographic z-axis is perpendicular to a surface of the piezoelectric layer 100. The interdigital transducer 200 is made of a metal, specific examples of which may include gold, silver, aluminum, copper, tungsten, titanium, nickel and metal alloys.

Reference is made to Figs. 2 to 4, which show schematic cross-sectional views of other surface acoustic wave resonators according to embodiments of the present application. As shown in figs. 2 to 4, according to other embodiments disclosed herein, the surface acoustic wave resonator 10 may further include a substrate layer 110, a trap layer 120 and/or a first dielectric layer 130, which are under the piezoelectric layer 100. The substrate layer 110 may be made of silicon, for example. The trap layer 120 may be made of polycrystalline silicon, for example. The first dielectric layer 130 may be made of, for example, silicon dioxide, silicon nitride or the like.

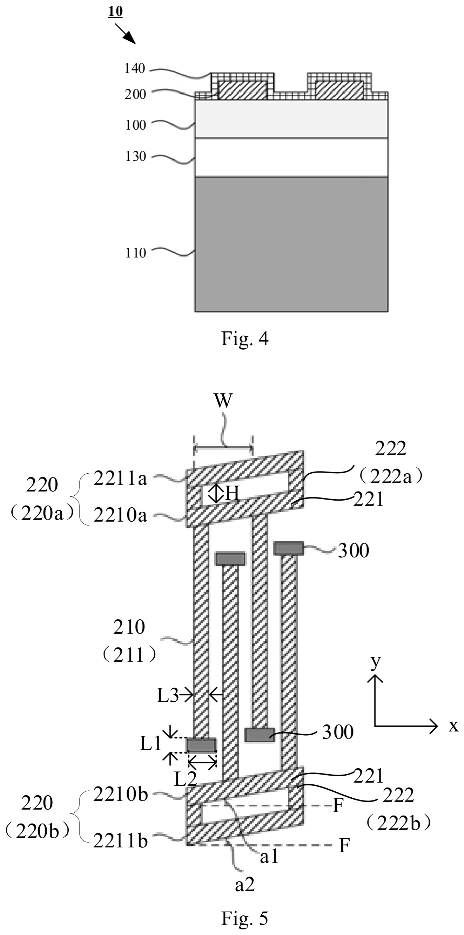

The surface acoustic wave resonator 10 may further include a second dielectric layer 140 covering the interdigital transducer 200. The second dielectric layer 140 may be made of, for example, silicon dioxide, silicon nitride or the like. The second dielectric layer 140 may be made of the same material as, or a different material from the first dielectric layer 130. For example, as shown in Figs. 1 and 4, the second dielectric layer 140 covers the interdigital transducer 200.

The surface acoustic wave resonator 10 may include all of the substrate layer 110, the trap layer 120, the first dielectric layer 130 and the second dielectric layer 140, or only one or more of them.

As shown in Fig. 2, in one embodiment disclosed herein, the surface acoustic wave resonator 10 may include the substrate layer 110 and the first dielectric layer 130, wherein the first dielectric layer 130 is located over the substrate layer 110, and the piezoelectric layer 100 is located over the first dielectric layer 130.

As shown in Fig. 3, in another embodiment disclosed herein, the surface acoustic wave resonator 10 may include the substrate layer 110, the trap layer 120 and the first dielectric layer 130, wherein the trap layer 120 is located over the substrate layer 110, the first dielectric layer 130 is located over the trap layer 120, and the piezoelectric layer 100 is located over the first dielectric layer 130.

As shown in Fig. 4, in yet another embodiment disclosed herein, the surface acoustic wave resonator 10 may include the substrate layer 110, the first dielectric layer 130 and the second dielectric layer 140, wherein the first dielectric layer 130 is located over the substrate layer 110, the piezoelectric layer 100 is located over the first dielectric layer 130, the interdigital transducer 200 is located over the piezoelectric layer 100, and the second dielectric layer 140 covers the interdigital transducer 200.

Reference is additionally made to Figs. 5 to 15, which show schematic top views of interdigital transducers in surface acoustic wave resonators according to embodiments of the present application. Reference is first made to Fig. 5, in one embodiment of the present application, the interdigital transducer 200 includes a plurality of interdigital electrodes 210 and two busbar sets 220 connected to the interdigital electrodes 210, referred to herein respectively as an upper busbar set 220a and a lower busbar set 220b.

Each busbar set 220 includes at least two busbars 221, which are arranged sequentially along the extension of the interdigital electrodes 210. Each busbar 221 is connected to an adjacent one of the busbars 221. Each busbar set 220 also includes connecting bars 222, which connect adjacent busbars 221 in the corresponding set.

In each busbar set 220, the busbar 221 that is closer to the interdigital electrode 210 forms an angle with a normal direction F of the interdigital electrodes 210. Mass blocks are provided at end portions of the interdigital electrodes 210, which can suppress lateral modes and reduce the acoustic velocity at ends of the interdigital electrodes 210, thereby confining energy within an associated resonant cavity with suppressed energy leakage and hence resulting in a greatly increased quality (Q) factor.

With continued reference to Fig. 5, in one embodiment disclosed herein, the upper busbar set 220a includes two busbars 221, referred to herein respectively as a first upper busbar 2210a and a second upper busbar 2211a. According to embodiments herein, two end portions of the first upper busbar 2210a are connected to two end portions of the second upper busbar 2211a. Specifically, the upper set 220a of busbars may further include two upper connecting bars 222a, which connect the two end portions of the first upper busbar 2210a to the two end portions of the second upper busbar 2211a.

Additionally, the lower busbar set 220b includes two busbars 221, referred to herein respectively as a first lower busbar 2210b and a second lower busbar 2211b. Two end portions of the first lower busbar 2210b are connected to two end portions of the second lower busbar 2211b. Specifically, the lower busbar set 220b may further include two lower connecting bars 222b, which connect the two end portions of the first lower busbar 2210b to the two ends portions of the second lower busbar 2211b.

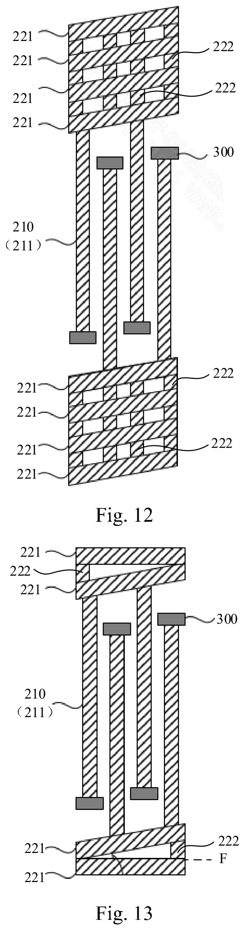

Alternatively, the upper busbar set 220a and the lower busbar set 220b may each include more busbars 221, for example, three, four, five or even more busbars 221. Moreover, in each busbar set 220, each busbar 221 may be connected, at either end portions or at any other location(s) than the end portions, such as at the middle and/or at any location(s) between end portions and the middle, to an adjacent busbar 221. For example, as shown in Fig. 12, the upper busbar set 220a and the lower busbar set 220b may each include four busbars 221. Moreover, in the example shown in Fig. 12, in each busbar set 220, each busbar 220 may be connected, particularly at both end portions and locations between the two end portions, by four connecting bars 222 to an adjacent busbar 221.

According to embodiments herein, the upper busbar set 220a may be of the same structure as the lower busbar set220b. In particular, the upper busbar set 220a may include the same number of busbars 221 as the lower set 220b of busbars, and the busbars 221 in the upper set may be of the same shape, and may be connected at the same location(s) in the same manner, as those in the lower set.

In alternative embodiments herein, the upper busbar set 220a and the lower busbar set 220b may be structured differently. For example, the upper busbar set 220a may include two busbars 221 that are connected only at two end portions, and the lower busbar set 220b may also include two busbars 221 that are connected at two end portions and at the middle portions. As another example, the upper busbar set 220a may include three busbars 221 each connected at two end portions to an adjacent busbar 221, while the lower busbar set 220b may include four busbars 221 each connected at two end portions to an adjacent busbar 221.

With continued reference to Fig. 5, in one embodiment disclosed herein, in each busbar set 220, the busbars 221 are oriented parallel to one another. In the illustrated embodiment, the first upper busbar 2210a and the second upper busbar 2211a are parallel to each other, and the first lower busbar 2210b and the second lower busbar 2211b are also parallel to each other.

In alternative embodiments herein, in each busbar set 220, the busbars 221 may be not mutually parallel. For example, the first upper busbar 2210a may not be parallel to the second upper busbar 2211a. As an example, as shown in Fig. 13, the first upper busbar 2210a may be oriented at an angle to the second upper busbar 2211a. Moreover, the first upper busbar 2210a and the second upper busbar 2211a may cross at their right ends (as viewed in the orientation of the figure). However, the first lower busbar 2210b may form an angle with the second lower busbar 2211b, and the first lower busbar 2210b and the second lower busbar 2211b cross each other at their left ends. In the embodiment of Fig. 13, the upper busbar set 220a may further include a single connecting bar 222, which connects a left end of the first upper busbar 2210a to a left end of the second upper busbar 2211a. Also, the lower busbar set 220b may include a single connecting bar 222, which connects a right end of the first lower busbar 2210b to a right end of the second lower busbar 2211b.

According to embodiments herein, the upper busbar set 220a may be of the same structure as the lower busbar set 220b. Accordingly, the following description focuses mainly on the lower busbar set 220b.

Specifically, in each busbar set 220, the busbar 221 closer to the interdigital electrode 210 may form an angle with the normal direction F of the interdigital electrodes 210. That is, the first upper busbar 2210a and the first lower busbar 2210b may be each form an angle with the normal direction F of the interdigital electrode 210. Here, in case of the upper busbar set 220a and the lower busbar set 220b being of the same structure, the angle between the first upper busbar 2210a and the normal direction F of the interdigital electrodes 210 may be equal to the angle between the first lower busbar 2210b and the normal direction F of the interdigital electrode 210.

With continued reference to Fig. 5, in each busbar set 220, an angle between the busbar 221 closer to the interdigital electrode 210 and the normal direction F of the interdigital electrodes 210 optionally ranges from 2° to 20°, or from -20° to -2°. In the illustrated embodiment, a first angle a1 between the first lower busbar 2210b and the normal direction F of the interdigital electrode 210 may range from 2° to 20°, or of from -20° to -2°. In other words, the clockwise or counterclockwise angle between the first lower busbar 2210band the normal direction of F of the interdigital electrode 210 may range from 2° to 20°. Optionally, the angle between the busbar 221 in each busbar set 220 closer to the interdigital electrode 210 and the normal direction F of the interdigital electrodes 210 may be equal to an angle of energy flow in the surface acoustic wave resonator 10. This can ensure coincident group and phase velocities, maximizing lateral mode suppression.

Optionally, in each busbar set 220, an angle between each remaining busbar 221and the normal direction F of the interdigital electrode 210 may range from -20° and 20°. That is, in each busbar set 220, the clockwise or counterclockwise angle between each remaining busbar 22 and the normal direction F of the interdigital electrode 210 may range from 0° to 20°. Thus, according to embodiments herein, in each busbar set 220, each remaining busbar 221 may be either parallel to, or may form an angle with, the normal direction F of the interdigital electrode 210. In the illustrated embodiment, a second angle a2 between the second lower busbar 2211b and the normal direction F of the interdigital electrode 210 may range from-20° to 20°.

With continued reference to Fig. 5, in each busbar set 220, a maximum distance H between adjacent busbars 221 may be optionally greater than or equal to a period W of the interdigital electrodes 210. This can enhance energy leakage suppression, resulting in a greatly increased Q factor. Here, the maximum distance H between adjacent busbars 221 in each busbar set 220 may be a maximum spacing between adjacent busbars 221 in each busbar set 220 along the extension of the interdigital electrodes 210, and the period W of the interdigital electrodes 210 may be a distance between adjacent interdigital electrodes 210 at their edges on the same side.

According to embodiments herein, in each busbar set 220, adjacent busbars 221 may be arranged in parallel, accordingly, a distance H between adjacent busbars 221 in each busbar set 220 is constant. That is, in each busbar set 220, a distance between adjacent busbars 221 at every location is equal. In alternative embodiments herein, in each busbar set 220, the busbars 221 may not be mutually parallel. In these cases, in each busbar set 220, a distance H between adjacent busbars 221 varies. Optionally, in each busbar set 220, the maximum distance H between adjacent busbars 221 may be optionally greater than or equal to the period W of the interdigital electrodes 210.

Further, in one embodiment disclosed herein, the interdigital electrodes 210 may comprise only active interdigital electrodes 211, the active interdigital electrodes 211 is connected at one end to one busbar set 220 and is provided with a mass block 300 at the other end. A line connecting (the centers of) the mass blocks 300 closer to the upper busbar set 220a may be either a straight line, or a polyline. Likewise, a line connecting (the centers of) the mass blocks 300 closer to the lower busbar set 220b may be either a straight line, or a polyline.

Fig. 5 schematically shows four active interdigital electrodes 211. Adjacent active interdigital electrodes 211 are connected to different of busbar sets 220. In the example shown in Fig. 5, mass blocks 300 are provided at ends of the active interdigital electrodes 211. In addition, a line connecting (the centers of) the mass blocks 300 closer to the upper busbar set 220a may be parallel to the first upper busbar 2210a, and a line connecting (the centers of) the mass blocks 300 closer to the lower busbar set 220b may be parallel to the first lower busbar 2210b. With this arrangement, the acoustic velocity may be better reduced at the ends of the interdigital electrodes 210.

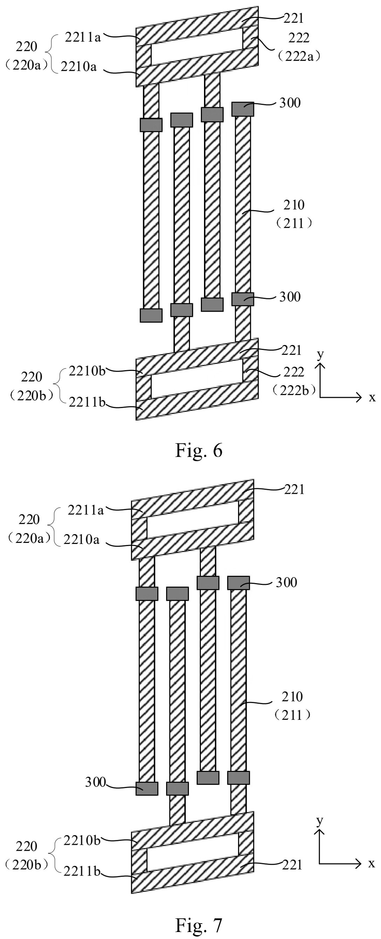

Referring to Figs. 6 and 7, in an alternative embodiment disclosed herein, additional mass blocks 300 may be provided on the active interdigital electrodes 211 at specified locations in addition to those at the end portions of the active interdigital electrodes 211. Optionally, the specified locations may correspond to the end portions of adjacent active interdigital electrodes 211.

Fig. 6 schematically shows four active interdigital electrodes 211, each provided with two mass blocks 300. A line connecting (the centers of) the mass blocks 300 closer to the upper busbar set 220a is parallel to the first upper busbar 2210a, and a line connecting (the centers of) the mass blocks 300 closer to the lower busbar set 220b is parallel to the first lower busbar 2210b.

Fig. 7 schematically shows four active interdigital electrodes 211, each provided with two mass blocks 300. The (centers of) four mass blocks 300 adjacent to the upper busbar set 220a are not collinear, likewise, the (centers of) four our mass blocks 300 adjacent to the lower busbar set 220a are not collinear. Among the mass blocks on the first and second active interdigital electrodes 211, the line connecting (the centers of) the two mass blocks 300 adjacent to the upper busbar set 220a is parallel to the normal direction F of the interdigitated electrode 210, and the line connecting (the centers of) the two mass blocks 300 adjacent to the lower busbar group 220b is parallel to the normal direction F of the interdigitated electrode 210. Similarly, among the mass blocks on the third and fourth active interdigital electrodes 211, the line connecting (the centers of) the two mass blocks 300 adjacent to the upper busbar set 220a is parallel to the normal direction F of interdigitated electrode 210, and the line connecting (the centers of) the two masse blocks 300 adjacent to the lower busbar set 220b is parallel to the normal direction F of interdigital electrode 210.

In an alternative embodiment disclosed herein, the interdigital electrodes 210 include active interdigital electrodes 211 and dummy interdigital electrodes 212. One end of the active interdigital electrodes 211 and one end of the dummy interdigital electrodes 212 are connected to different busbar sets 220. Additionally, the other end of the active interdigital electrodes 211 and/or the other end of the dummy interdigital electrodes 212 are provided with a mass block 300. A line connecting (the centers of) the mass blocks 300 on the active interdigital electrodes 211 that are closer to the upper busbar set 220a may be either a straight line, or a polyline. A line connecting (the centers of) the mass blocks 300 on the dummy interdigital electrodes 212 that are closer to the upper busbar set 220a may be either a straight line, or a polyline. A line connecting (the centers of) the mass blocks 300 on the active interdigital electrodes 211 that are closer to the lower busbar set 220b may be either a straight line, or a polyline. A line connecting (the centers of) the mass blocks 300 on the dummy interdigital electrodes 212 that are closer to the lower busbar set 220b may be either a straight line, or a polyline.

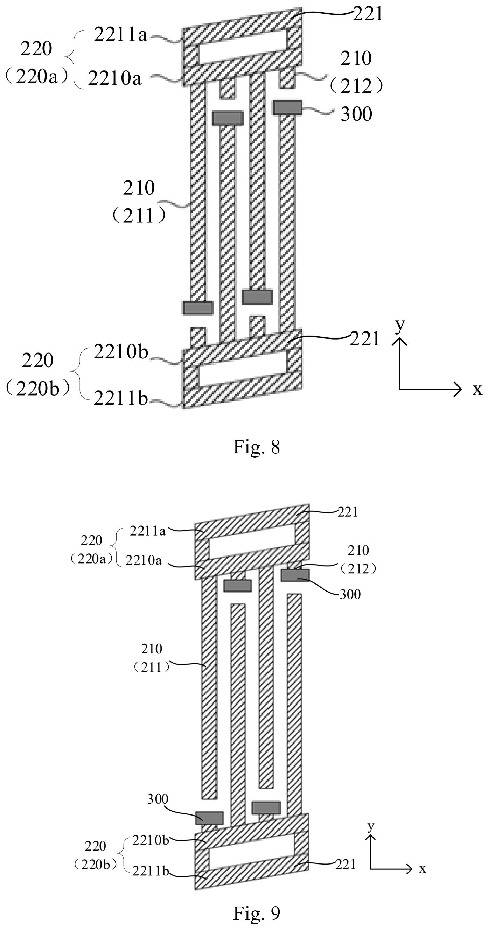

Fig. 8 schematically shows four active interdigital electrodes 211 and four respective associated dummy interdigital electrodes. Only the active interdigital electrodes 211 are each provided at its one end with a mass block 300. Further, a line connecting (the centers of) the mass blocks 300 closer to the upper busbar set 220a may be parallel to the first upper busbar 2210a, and a line connecting (the centers of) the mass blocks 300 closer to the lower busbar set 220b may be parallel to the first lower busbar 2210b.

Fig. 9 schematically shows four active interdigital electrodes 211 and four respective associated dummy interdigital electrodes. Only the dummy interdigital electrodes 212 are each provided at its one end with a mass block 300. Further, a line connecting (the centers of) the mass blocks 300 closer to the upper busbar set 220a may be parallel to the first upper busbar 2210a, and a line connecting (the centers of) the mass blocks 300 closer to the lower busbar set 220b may be parallel to the first lower busbar 2210b.

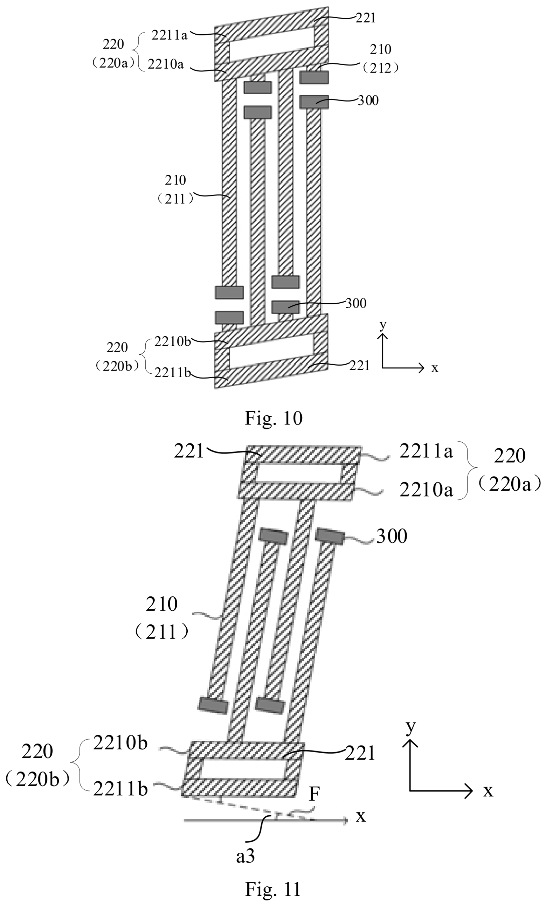

Fig. 10 schematically shows four active interdigital electrodes 211 and four respective associated dummy interdigital electrodes. The active interdigital electrodes 211 and the dummy interdigital electrodes 212 are each provided at its one end with a mass block 300. A line connecting (the centers of) the mass blocks 300 at the ends of the active interdigital electrodes 211 that are closer to the upper busbar set 220a is parallel to the first upper busbar 2210a. A line connecting (the centers of) the mass blocks 300 at the ends of the dummy interdigital electrodes 212 that are closer to the upper busbar set 220a is parallel to the first upper busbar 2210a. A line connecting (the centers of) the mass blocks 300 at the ends of the active interdigital electrodes 211 that are closer to the lower busbar set 220b is parallel to the first lower busbar 2210b. A line connecting (the centers of) the mass blocks 300 at the ends of the dummy interdigital electrodes 212 that are closer to the lower busbar set 220b is parallel to the first lower busbar 2210b.

In alternative embodiments herein, additional mass blocks 300 may be provided on the active interdigital electrodes 211 and/or the dummy interdigital electrodes 212 at specified locations, in addition to those at ends of the active interdigital electrodes 211 and/or the dummy interdigital electrodes 212. Optionally, the specified locations may correspond to the ends of adjacent active interdigital electrodes 211 and/or dummy interdigital electrodes 212.

Further, according to embodiments herein, the mass blocks 300 may be provided on a surface of the surface acoustic wave resonator 10 and rectangular in shape. In alternative embodiments herein, the mass blocks 300 may be otherwise shaped, such as circular, X- or V-like. The mass blocks 300 on the interdigital electrodes 210 may be of the same shape, or not.

Optionally, a ratio of a length L1 of the mass blocks 300 to the period W of the interdigital electrodes 210 may range from 0.25 to 1. The length L1 of the mass blocks 300 is a maximum dimension thereof along the extension of the interdigital electrodes 210. A ratio of a width L2 of the mass blocks 300 to a width L3 of the interdigital electrodes 210 may range from 1.2 to 2. The width L2 of the mass blocks 300 may be a maximum dimension thereof along the normal direction F of the interdigital electrodes 210. With this arrangement, not only effective suppression of energy leakage but also efficient transmission of acoustic waves can be ensured.

Exemplary materials for the mass blocks 300 may include metals and/or dielectric materials. For example, the mass block 300 may be made of a material including gold, silver, aluminum, copper, tungsten, silicon, silicon dioxide, polycrystalline silicon, silicon nitride or the like. The mass blocks 300 may be in the same layer as the interdigital transducer 200. Alternatively, the mass blocks 300 and the interdigital transducer 200 may be in different layers. The mass blocks 300 may comprise multiple mass layers, one mass layer may be in the same layer as the interdigital transducer 200. The present application is not limited in this regard in any sense. For multiple mass layers, the multiple mass layers may be of the same shape and/or size, or of different shapes and/or sizes, without limiting the present application.

With continued reference to Figs. 5 to 10, 12 and 13, in one embodiment disclosed herein, the normal direction F of the interdigital electrodes 210 extends along the crystallographic x-axis of the piezoelectric layer 100, that is, the interdigital electrodes 210 extend along the crystallographic y-axis of the piezoelectric layer 100. In this case, the extension of each of the first upper busbar 2210a and the first lower busbar 2210b may form an angle with the normal direction F of the interdigital electrodes 210. That is, the extension of each of the first upper busbar 2210a and the first lower busbar 2210b may form an angle with the crystallographic x-axis of the piezoelectric layer 100. In other words, an angle between the extension of each of the first upper busbar 2210a and the first lower busbar 2210b and the normal direction F of the interdigital electrodes 210 may be equal to an angle between the extension of each of the first upper busbar 2210a and the first lower busbar 2210b and the crystallographic x-axis of the piezoelectric layer 100.

Referring to Fig. 11, in an alternative embodiment disclosed herein, the normal direction F of the interdigital electrodes 210 forms an angle with the crystallographic x-axis of the piezoelectric layer 100, that is, the extension of each of the first upper busbar 2210a and the first lower busbar 2210b forms angle with the normal direction F of the interdigital electrodes 210. In the embodiment shown in Fig. 11, the first upper busbar 2210a and the first lower busbar 2210b both extend along the crystallographic x-axis of the piezoelectric layer 100. Optionally, a third angle a3 between the normal direction F of the interdigital electrodes 210 and the crystallographic x-axis of the piezoelectric layer 100 (clockwise and/or counterclockwise) may range from 0° to 15°. In this case, the extension of each of the first upper busbar 2210a and the first lower busbar 2210b may either along the crystallographic x-axis of the piezoelectric layer 100, or form an angle with the crystallographic x-axis of the piezoelectric layer 100. For example, an angle between the extension of each of the first upper busbar 2210a and the first lower busbar 2210b and the crystallographic x-axis of the piezoelectric layer 100 may range from 0° to 15° (clockwise and/or counterclockwise).

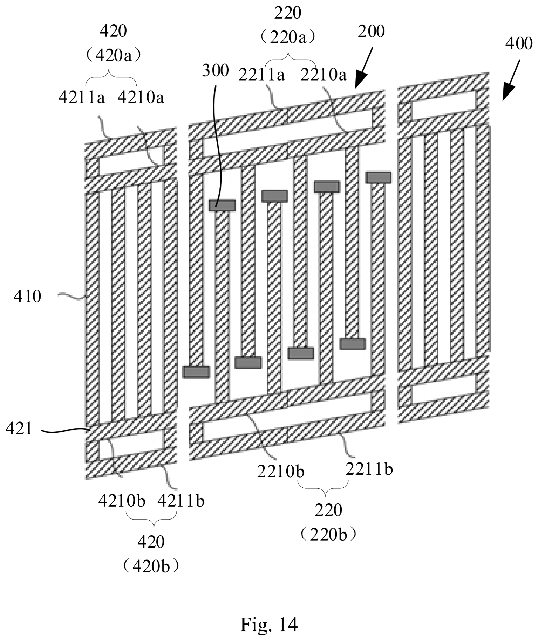

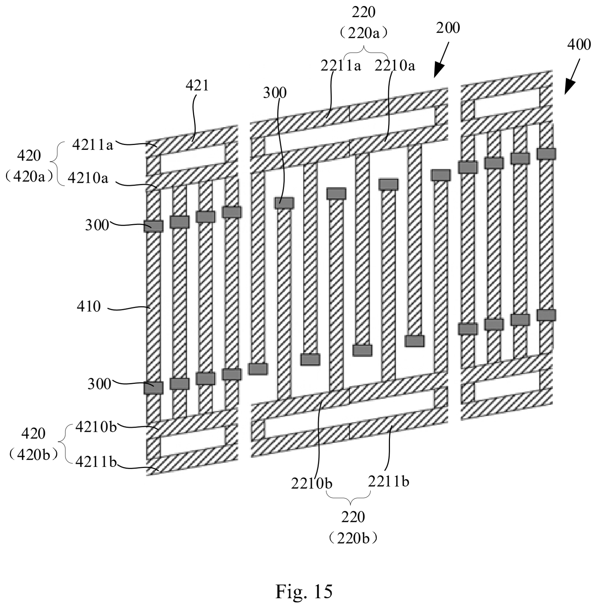

With additional reference to Figs. 14 and 15, the surface acoustic wave resonator 10 further includes reflectors 400 disposed on opposite sides of the interdigital transducer 200. In the illustrated embodiment, the surface acoustic wave resonator 10 includes two reflectors 400 disposed on the respective opposite sides of the interdigital transducer 200.

The reflector 400 includes a reflector grating 410 and two sets of reflector busbars 420 connected to the reflector grating 410, referred to herein respectively as an upper reflector busbar set 420a and a lower reflector busbar set 420b. The upper reflector busbar set 420a may be of the same structure as the lower reflector busbar set 420b. Alternatively, the two sets may be structured differently.

With continued reference to Fig. 14 or 15, according to embodiments herein, each reflector busbar set 420 includes at least two reflector busbars 421. Specifically, the upper reflector busbar set 420a may include a first upper reflector busbar 4210a and a second upper reflector busbar 4211a, and the lower reflector busbar set 420b may include a first lower reflector busbar 4210b and a second lower reflector busbar 4211b. The first upper reflector busbar 4210a is connected to the second upper reflector busbar 4211a, and the first lower reflector busbar 4210b is connected to the second lower reflector busbar 4211b. Likewise, in each reflector busbar set 420, adjacent reflector busbars 421 may be connected by connecting bars (not shown), either at their end portions, or at other locations than the end portions. For example, end portions of the first upper reflector busbar 4210a may be connected to end portions of the second upper reflector busbar 4211a, and end portions of the first lower reflector busbar 4210b may be connected to end portions of the second lower reflector busbar 4211b.

Optionally, the first upper reflector busbar 4210a may be collinear with the first upper busbar 2210a, and the second upper reflector busbar 4211a may be collinear with the second upper busbar 2211a. Additionally, the first lower reflector busbar 4210b may be collinear with the first lower busbar 2210b, and the second lower reflector busbar 4211b may be collinear with the second lower busbar 2211b.

As shown in Fig. 14 or 15, the reflector grating 410 is connected at opposite ends respectively to the first upper reflector busbar 4210a and the first lower reflector busbar 4210b. As shown in Fig. 14, in one embodiment disclosed herein, the reflector grating 410 is not provided with any mass block. As shown in Fig. 15, in another embodiment disclosed herein, the reflector grating 410 is provided with mass blocks 300.A line connecting (the centers of) mass blocks 300 closer to the upper reflector busbar set 420a is parallel to the first upper reflector busbar 4210a, and a line connecting (the centers of) mass blocks 300 closer to the lower reflector busbar set 420b is parallel to the first lower reflector busbar 4210b.

As shown in Fig. 15, a line connecting the mass blocks 300 on the reflector gratings 410 that are closer to the upper reflector busbar set 420a and (the centers of) mass blocks 300 on the interdigital electrodes 210 closer to the upper busbar set 220a may be either a straight line, or a polyline. Similarly, a line connecting the mass blocks 300 on the reflector gratings 410 that are closer to the lower set 420b of reflector busbars and (the centers of) mass blocks 300 on the interdigital electrodes 210 closer to the lower set 220b of busbars may be either a straight line, or a polyline.

According to embodiments herein, an interdigital transducer includes a plurality of interdigital electrodes and two busbar sets both connected to the interdigital electrodes. In each busbar set, the busbar that is closer to the interdigital electrode forms an angle with a normal direction of the interdigital electrodes, thus providing for lateral mode suppression. In addition, mass blocks are provided at end portions of the interdigital electrodes to reduce the acoustic velocity at these ends. Further, each busbar set includes at least two busbars and adjacent busbars are connected. This enables energy confinement within an associated resonant cavity with suppressed energy leakage, eventually resulting in a greatly increased Q factor.

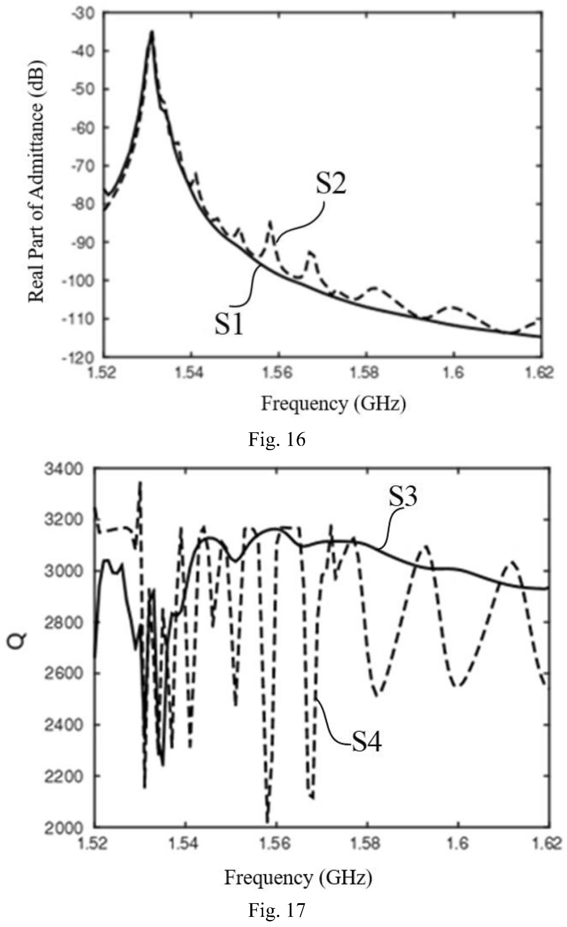

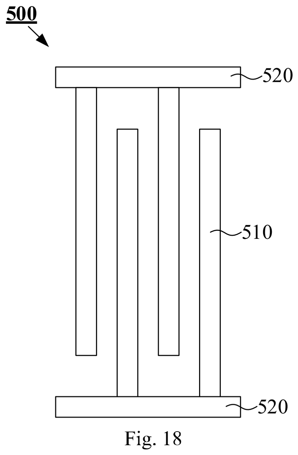

Figs. 16 and 17 schematically illustrate lateral-mode response and Q factor comparisons made between a surface acoustic wave resonator according to an embodiment of the present application and a conventional surface acoustic wave resonator. The surface acoustic wave resonator according to embodiment of the present application includes an interdigital transducer of the exemplary structure shown in fig. 5, and the conventional surface acoustic wave resonator includes an interdigital transducer structured as shown in Fig. 18, as an example. The conventional interdigital transducer 500 includes interdigital electrodes 510 and busbars 520 connected to the interdigital electrodes 510, the busbar 520 is parallel to a normal direction of the interdigital electrodes 510.

In Figs. 16 and 17, S1 denotes a graph plotting the real part of the admittance of the surface acoustic wave resonator according to embodiment of the present application, and S2 denotes a graph plotting the real part of the admittance of the conventional surface acoustic wave resonator. Moreover, S3 denotes a Q-factor graph of the surface acoustic wave resonator according to embodiment of the present application, and S4 denotes a Q-factor graph of the conventional surface acoustic wave resonator. As can be seen from Figs. 16 and 17, the surface acoustic wave resonator according to embodiment of the present application is capable of effectively suppressing lateral mode response and exhibits an overall high in-band Q factor. Additionally, it effectively suppresses energy leakage around the anti-resonance frequency and provides a significantly increased Q factor.

Embodiments of the present application also provide a method for fabricating a surface acoustic wave resonator, which corresponds to the surface acoustic wave resonator embodiments that have been described above with reference to Figs. 1 to 15. Specifically, the method comprises the steps of:
S10: providing a piezoelectric layer 100;
S11: forming an interdigital transducer 200 on the piezoelectric layer 100, , wherein the interdigital transducer 200 comprises a plurality of interdigital electrodes 210 and two busbar sets 220 connected to the interdigital electrodes 210, each busbar set 220 comprising at least two busbars 221and adjacent busbars 221 connected, wherein in each busbar set 220, the busbar 221 that is closer to the interdigital electrode 210 is oriented at an angle to a normal direction F of the interdigital electrodes 210; and
S12: forming mass blocks 300 at end portions of the interdigital electrodes 210.

Step S11 may precede, or concur with, step S12. Alternatively, step S12 may precede step S11. Still alternatively, steps S11 and S12 may be carried out in an interleaved manner.

The formation of the interdigital transducer 200 on the piezoelectric layer 100 may include: forming a metal layer (not shown) on the piezoelectric layer 100; and forming the interdigital transducer 200 by etching the metal layer. In alternative embodiments herein, a patterned photoresist or dielectric layer may be first formed on the piezoelectric layer 100, which exposes a portion of the piezoelectric layer 100; subsequently, forming a metal layer, which covers the patterned photoresist or dielectric layer and the exposed portion of the piezoelectric layer 100; and then forming the interdigital transducer 200, optionally by lifting off the patterned photoresist or dielectric layer.

In one embodiment disclosed herein, the mass blocks 300 may comprise a metal mass layer (not shown), when the metal layer is etched to form the interdigital transducer 200, the metal mass layer is formed. In this case, steps S11 and S12 may be considered to concur with each other.

In an alternative embodiment disclosed herein, the mass blocks 300 may comprise multiple mass layers including, for example, a metal mass layer and a dielectric mass layer on the metal mass layer. For example, a metal layer may be formed on the piezoelectric layer 100 and the metal layer is etched to form both the interdigital transducer 200 and the metal mass layer. Subsequently, a dielectric layer may be formed over the interdigital transducer 200 and the metal mass layer and the dielectric layer is etched to form the dielectric mass layer.

In alternative non-limiting embodiments herein, the mass block 300 may comprise multiple metal mass layers and/or multiple dielectric mass layers under the interdigital transducer 200, and/or multiple metal mass layers and/or multiple dielectric mass layers over the interdigital transducer 200.

The description presented above is merely that of some preferred embodiments of the present application and does not limit the scope thereof in any sense. Any and all changes and modifications made by those of ordinary skill in the art based on the above teachings fall within the scope as defined in the appended claims.

## Claims

1. A surface acoustic wave resonator, comprising a piezoelectric layer and an interdigital transducer formed on the piezoelectric layer,
wherein the interdigital transducer comprises a plurality of interdigital electrodes and two busbar sets connected to the interdigital electrodes, wherein each busbar set comprises at least two busbars and adjacent busbars are connected, wherein in each busbar set, the busbar that is closer to the interdigital electrode is oriented at an angle to a normal direction of the interdigital electrode, and wherein a mass block is provided at an end portion of the interdigital electrode.

2. The surface acoustic wave resonator of claim 1, wherein the busbar that is closer to the interdigital electrode in each busbar set is oriented at an angle to a crystallographic x-axis of the piezoelectric layer.

3. The surface acoustic wave resonator of claim 1, wherein the two busbar sets are of the same structure.

4. The surface acoustic wave resonator of any one of claims 1 to 3, wherein adjacent busbars in each busbar set are arranged in parallel or at an angle to each other.

5. The surface acoustic wave resonator of any one of claims 1 to 3, wherein the busbar set further comprises at least one connecting bar, and wherein adjacent busbars in each busbar set are connected through the connecting bar.

6. The surface acoustic wave resonator of any one of claims 1 to 3, wherein a maximum distance between adjacent busbars in each busbar set is greater than or equal to a period of the interdigital electrodes.

7. The surface acoustic wave resonator of any one of claims 1 to 3, wherein the angle between the busbar closer to the interdigital electrode in each busbar set and the normal direction of the interdigital electrode ranges from 2° to 20°, or from -20° to -2°.

8. The surface acoustic wave resonator of any one of claims 1 to 3, wherein the interdigital electrodes only comprise active interdigital electrodes, wherein a first end of the active interdigital electrode is connected to the busbar set and a second end of the active interdigital electrode is provided with a mass block; or
wherein the interdigital electrodes comprise active interdigital electrodes and dummy interdigital electrodes, wherein a first end of the active interdigital electrode and a first end of the dummy interdigital electrode are connected to different busbar sets, and a second end of the active interdigital electrode and/or a second end of the dummy interdigital electrode provided with a mass block.

9. The surface acoustic wave resonator of any one of claims 1 to 3, wherein a ratio of a length of the mass block to a period of the interdigital electrode is between 0.25 and 1, and wherein the length of the mass block is a maximum dimension of the mass block along an extension of the interdigital electrode, and
wherein a ratio of a width of the mass block to a width of the interdigital electrode is between 1.2 and 2, and wherein the width of the mass block is a maximum dimension of the mass block along the normal direction of the interdigital electrode.

10. The surface acoustic wave resonator of any one of claims 1 to 3, further comprising reflectors located on opposite sides of the interdigital transducer.

11. The surface acoustic wave resonator of any one of claims 1 to 3, further comprising: a substrate layer, a trap layer and/or a first dielectric layer that are under the piezoelectric layer; and/or a second dielectric layer covering the interdigital transducer.

12. The surface acoustic wave resonator of any one of claims 1 to 3, the angle between the busbar closer to the interdigital electrodes in each busbar set and the normal direction of the interdigital electrode is equal to an angle of energy flow in the surface acoustic wave resonator.

13. A method for fabricating a surface acoustic wave resonator, comprising:
providing a piezoelectric layer;
forming an interdigital transducer on the piezoelectric layer, wherein the interdigital transducer comprises a plurality of interdigital electrodes and two busbar sets connected to the interdigital electrodes, wherein each busbar set comprises at least two busbars and adjacent busbars are connected, wherein in each busbar set, the busbar that is closer to the interdigital electrode is oriented at an angle to a normal direction of the interdigital electrode; and
forming a mass block at an end portion of the interdigital electrode.

14. The method for fabricating the surface acoustic wave resonator of claim 13, wherein forming the interdigital transducer on the piezoelectric layer comprises:
forming a metal layer on the piezoelectric layer; and
etching the metal layer to form the interdigital transducer.

15. The method for fabricating the surface acoustic wave resonator of claim 14, wherein the mass block comprises a metal mass layer, and wherein when the metal layer is etched to form the interdigital transducer, the metal mass layer is formed.
